# EUROPEAN PATENT SPECIFICATION

(11) **EP 3 379 327 B1**
(45) Date of publication and mention of the grant of the patent: **23.10.2019**
(21) Application number: 18162932.0
(22) Date of filing: 20.03.2018
(51) Int. Cl.: G02F 1/13357, H05K 7/20

(54) **DISPLAY PANEL FOR DIGITAL SIGNS**
ANZEIGETAFEL FÜR DIGITALE SCHILDER
PANNEAU D'AFFICHAGE POUR PANNEAUX NUMÉRIQUES

(30) Priority: 22.03.2017 IT 201700031356
(43) Date of publication of application: 26.09.2018
(73) Proprietor: IMECON ENGINEERING S.R.L., 26010 Fiesco (CR) (IT)
(72) Inventor: VAIRANI, Alessio, I-26012 Castelleone (CR) (IT); VAIRANI, Fabio, I-26013 Crema (CR) (IT)
(74) Representative: Porta & Consulenti Associati S.p.A.

(56) References cited:
- US-A1- 2011 013 114
- US-A1- 2011 019 363

## Description

The present invention relates to an electronic panel for digital signs.

Electronic panels for digital signs are for reproducing both static and dynamic images on the surface of a display. Such panels provide a support for a lighting system (known in technical jargon by the term of "backlight") that illuminates a display in a controlled manner.

The backlight includes an array of LED diodes, or in any case an array of light sources capable of emitting light in a manner that is controlled and driven both in time and in space (such as cold cathode fluorescent lamps), and the display is usually an LCD or other type of display.

Between the display and the backlight is placed a plurality of layers having predetermined optical properties, such as for example a vertical diffuser layer, a horizontal diffuser layer, a diagonal diffuser layer, a polarizing layer and other layers.

These layers have the task of presenting in a controlled manner the light emitted by the array of light sources to the liquid crystal display. Further layers are arranged downstream of the latter, such as for example an RGB filter layer and a polarizing layer.

The backlight, as mentioned, has the function of sending light to the display and, in the most common applications, the backlight includes a support panel on which the light source arrays are installed. The light sources are driven by a circuitry (called driver) arranged to turn on and off the individual light sources as a function of received driving signals.

Electronic panels for the digital signs are widely used both in indoor applications and in outdoor applications to convey advertising messages, information, movies and more.

In these applications it is essential to ensure both the correct disposal of the heat produced by the electronic panel and the possibility to perform maintenance operations on the panel.

The electronic panel must in fact be able to operate continuously 24 hours a day and seven days a week, even when exposed to atmospheric agents and to the seasonal and daily environmental conditions of the place in which it is installed.

Consider for example that the backlight of a 90-inch electronic panel produces a thermal power of about 3 kilowatts, and if exposed to the external environment, the solar radiation that impinges the panel can transmit thermal powers of the order of 1.5 kilowatts to the same on sunny days.

In these extreme operating situations, maintenance operators must be able to easily access the internal components of the panel in order to restore the panel in case of malfunctions or to be able to update the panel in case of improvements.

In this regard, the drivers are grouped on electronic boards mounted on a first surface of the backlight support panel. The light sources, which are directly facing the screen, are mounted on the opposite surface of the backlight support panel.

The backlight and the display are accommodated in a containment casing provided with a removable or in any case opening rear wall to allow access to the first surface of the backlight support panel and thus to the drivers.

The heat generated by the backlight is removed by cooling the drivers, that is, the surface of the backlight support panel that carries the electronic boards.

Therefore, it is known to provide an air chamber between the first surface of the backlight support panel and the removable rear wall of the containment casing to allow a flow of cooling air to impinge the drivers.

This flow of cooling air can be generated by a cooling system equipped with a compressor and an evaporator (usually placed at the base of the casing out of the backlight and the display) or by providing a "passive" cooling system, that is to say, that does not use air cooling systems but that draws air from the external environment and sends it inside the air chamber and then extracts it from the same and re-enters it into the external environment.

In both cases, access to the drivers is ensured by the access to the air chamber placed between the backlight and the rear wall of the containment casing.

Since it is also necessary to remove heat which is transmitted to the electronic panel by solar radiation, it is often necessary to provide cooling systems capable of removing heat from the front surface of the display.

An example of these cooling systems is described in document EP2225603B1 and provides a closed loop circuit in which a cooling gas circulates. This closed circuit develops at the front of the LCD, continues laterally to the display and closes at the back behind the backlight. In the region behind the backlight, the closed loop circuit is distanced from the backlight so as to form the above air chamber. In such an air chamber, a stream of forced air is made to pass, drawn from the external environment and reintroduced in the external environment, which impinges the backlight and the drivers at the back. In this way, the cooling gas removes heat from the display by convection and is cooled by the air flow drawn from the external environment.

An electronic panel having the features of the preamble of claim 1 is known from US 2011/0019363 A1.

The Applicant has noted that in the prior art devices, such as the one described in EP2225603B1, access to the backlight and to the drivers is not always easy because it is hindered by the presence of the closed loop circuit.

The Applicant has also noted that in the prior art devices, the electronic panel must be installed by providing, at the back of the device, the necessary space to allow maintenance personnel to open or disassemble the rear wall of the containment casing.

The present invention therefore relates to an electronic panel for digital signs comprising the features of the appended claim 1.

The backlight assembly is configured to send, to the display assembly, electromagnetic radiation in the visible spectrum in a manner that is controlled and driven both in time and in space.

The display assembly is configured to intercept the radiation sent by the backlight assembly and display static and/or moving images.

The Applicant has perceived that by making the backlight assembly and the display assembly as physically distinct and separate elements, it is possible to make the display assembly movable with respect to the backlight assembly.

In this way, the display assembly can take an operating condition in which it is directly facing the backlight assembly and is capable of displaying static and/or moving images, and a non-operating condition in which it can be moved with respect to the backlight.

The non-operating condition of the display assembly allows, through the front opening of the containment structure, to directly access the backlight assembly to perform maintenance and/or update operations of the electronic panel in a simple and effective way.

Hereinafter in the present description and in the following claims, the terms "transverse" and "transversally" are used with reference to a substantially horizontal direction perpendicular to the display assembly when in the operating condition. In particular, the term "transversally front" or "transversally outside" identifies a position facing towards the outside and the term "transversally inside" identifies a position facing towards the inside of the panel.

The term "axial" is used referring to a substantially horizontal direction perpendicular to the transverse direction.

The expressions "axially inner" and "axially outer" respectively indicate a positioning which is more internal to the electronic panel, i.e., more towards the center of the electronic panel, and more external, that is to say, more towards the periphery of the electronic panel.

The expression "front" indicates a position facing the front of the electronic panel, that is to say, the part of an electronic panel that allows a user to view the projected images.

The expression "rear" indicates a position facing the back of the electronic panel, that is to say, a position transversely opposite to the front one.

The electronic panel according to the present invention may comprise one or more of the following preferred features, taken individually or in combination.

Preferably, said display assembly is hinged to said containment structure and said backlight assembly is fixed with respect to said containment structure.

In this way, the transition from the operating to the non-operating condition of the display assembly can be carried out simply by rotating the display assembly with respect to the containment structure.

Preferably, said display assembly, in the operating condition, fluid-tightly closes said backlight assembly in said containment structure and, in the non-operating condition, exposes said backlight assembly to the environment external to said containment structure.

In this way, when the display assembly is in the non-operating condition, the backlight assembly is directly facing the front opening of the containment structure and is easily reachable by an operator.

According to claim 1, said backlight assembly is mounted on a first heatsink, on a front surface thereof facing said front opening of said containment structure.

Coupling the backlight assembly to the first heatsink allows the backlight assembly to be cooled and, at the same time, to support the backlight assembly within the containment structure.

According to claim 1, said plurality of light sources and electronic devices for driving the same are mounted on said front surface of the first heatsink.

This allows easy maintenance of the light sources and electronic driving devices when the display assembly is in the non-operating condition.

Preferably, said electronic devices for driving the light sources are thermally coupled to said first heatsink.

In this way, the backlight assembly can be cooled by thermal conduction with the surface of the heatsink. Since most of the heat of the backlight assembly is produced by the electronic driving devices, the cooling by thermal conduction of the latter allows an efficient cooling of the whole system.

The assembly of the electronic driving devices directly on the front surface of the heatsink, upon possible interposition of a thermally conductive and electrically non-conductive paste, obtains the double effect of positioning the backlight assembly directly facing the front opening of the containment structure and of cooling down the backlight assembly very efficiently (by conduction).

Preferably, said front surface of the first heatsink comprises a plurality of recesses in which are accommodated said electronic devices for driving the light sources.

Preferably, the electronic driving devices are housed in the recesses without the electronic driving devices emerging with respect to the front surface of the heatsink.

In this way, the light sources can be mounted on the front surface of the heatsink in such a way as to provide a flat surface behind which the relevant electronic driving devices are placed.

Preferably, said first heatsink comprises a plurality of modules provided with respective inner through cavities placed in fluid communication with the environment external to said containment structure.

In this way, depending on the axial dimensions of the backlight assembly, the first heatsink can be assembled by axially placing side by side an adequate number of modules, without the need for monolithic, customized heatsinks.

Moreover, in the inner recesses of each module, air flows from the external environment to the containment structure which allows cooling of the heatsink.

Preferably, said containment structure and said display assembly, in the operating condition, define a first closed circuit wherein a cooling fluid circulates which laps the backlight assembly.

The provision of a closed circuit between the display assembly and the backlight assembly allows heat to be removed by convection from the front surface of the backlight assembly avoiding such a heat from massively reaching the display assembly and accumulating in the gap between the display assembly and the backlight assembly, thus creating a considerable thermal inertia in the panel.

Preferably, in each through cavity of the modules of the first heatsink, a respective fan is active which draws air from the environment external to the panel and sends it inside the through cavity.

Preferably, the first heatsink is a body made of a metal material provided with cooling fins. The cooling fins are placed inside the through cavities and protrude radially towards the center of the respective cavity, in such a way as to maximize the heat exchange with the first heatsink cooling circuit flow.

Preferably, said first closed circuit comprises a thermal regeneration chamber for said cooling fluid, thermally associated with said first heatsink.

The cooling fluid which removes heat by convection from the backlight assembly is cooled in the thermal regeneration chamber. This is preferably done by flowing the heated fluid onto the first heatsink in the thermal regeneration chamber.

In this way, the cooling fluid can be re-introduced between the front surface of the backlight assembly and the display assembly and again remove heat from the front surface of the backlight assembly.

The heatsink which has the function of cooling the backlight assembly by thermal conduction also has the function of cooling the fluid of the closed circuit.

Preferably, said display assembly comprises an LCD matrix coupled to a diffuser screen; said diffuser screen, in the operating condition of the display assembly, fluid-tightly closes said front opening of the containment structure.

Preferably, the diffuser screen is made of a material having a low thermal conductivity, such as glass. Thin layers of polymeric material are preferably applied on one or both surfaces of the diffuser screen in which the layers of polymeric material act as polarizers.

Preferably, a front screen is movable between an operating condition wherein it is facing said display assembly on the side opposite to the backlight assembly, and a non-operating condition wherein it is moved away from said display assembly.

The front screen is preferably an outermost screen of the electronic panel and ensures, when in the operating condition, that between the front screen and the display assembly no fluid (water or gas) or dust can penetrate from the external environment.

Preferably, the front screen is made of a material having a low thermal conductivity, such as glass.

The non-operating condition of the front screen provides access to the display assembly in order to be able to switch between the operating and the non-operating condition.

Preferably, said front screen and said display assembly define, when they are in their respective operating conditions, a second closed circuit wherein a cooling fluid circulates which laps said display assembly.

The second closed circuit draws heat between the front screen and the display assembly, preventing the front screen (exposed to the sun or otherwise to the external environment) from transmitting significant thermal energy to the display assembly.

Preferably, said second closed circuit comprises a thermal regeneration chamber for said cooling fluid, thermally associated with a second heatsink.

Further features and advantages of the present invention will appear more clearly from the following detailed description of some preferred embodiments thereof, made with reference to the accompanying schematic drawings, given by way of nonlimiting example. In such drawings:
- figure 1 is a schematic top sectional view of an electronic panel for digital signs in a first operating configuration according to the present invention;
- figure 2 is the electronic panel in figure 1 in a second operating configuration;
- figure 3 is a lateral view of the electronic panel in figure 1 in a third operating configuration;
- figure 4 is the electronic panel in figure 1 in which further features are highlighted;
- figure 5 is a view according to section V-V of the electronic panel in figure 4;
- figure 6 is a view according to section VI-VI of the panel in figure 4;
- figure 7 is a top sectional view of an electronic panel for digital signs according to the present invention according to an embodiment variant;
- figure 8 is a front view of a detail of the electronic panel in figure 1 and 7; and
- figure 9 is a perspective view of some details in figure 8.

In the accompanying figures, reference numeral 10 indicates an electronic panel for digital signs according to the present invention.

The electronic panel 10 comprises a containment structure 11 which defines the overall dimensions of the electronic panel 10.

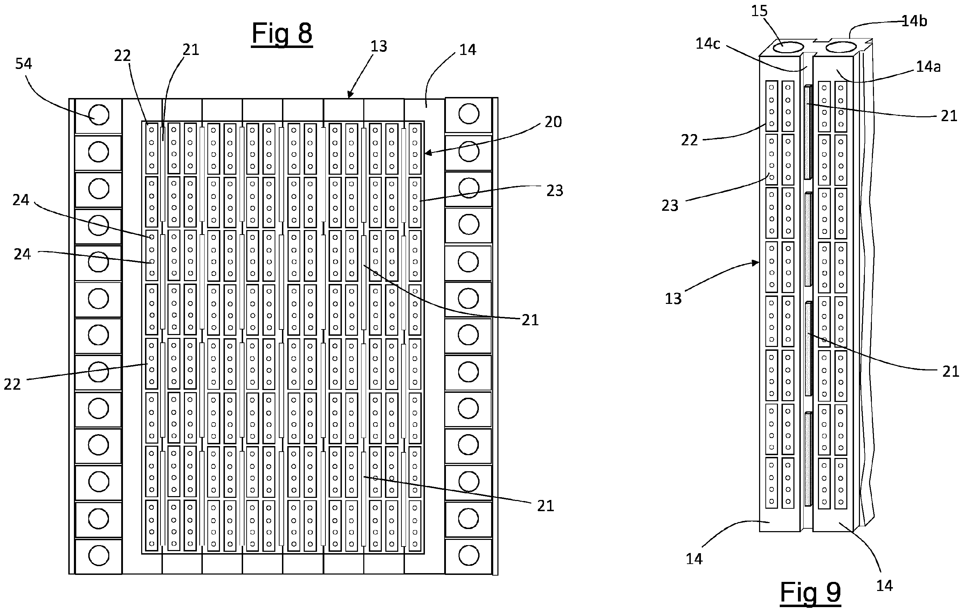

Inside the containment structure 11 there is housed a backlight assembly 20 which comprises a plurality of electronic driving devices 21 and a plurality of light sources 22 driven by the electronic devices 21, schematically illustrated in figure 8.

In the preferred embodiment of the invention, the light sources 22 are led diode arrays and the electronic driving devices 21 are led drivers. In the remainder of the present description, reference will be made to LED drivers 21 and LED matrixes 22, also meaning more generic electronic driving devices and more generic light sources.

The containment structure 11 has a front opening 12 on which the backlight assembly 20 faces, so that the light sources 22 radiate light towards the front opening 12.

The front opening 12 is fluid-tight closed by a display assembly 30 which, in the preferred embodiment of the invention, comprises a plurality of layers forming an LCD matrix 31.

The LCD matrix 31 is placed frontally to the backlight assembly 20 in order to be illuminated directly thereby.

The plurality of layers (not shown in detail) which forms the LCD matrix can for example comprise diffuser layers, polarizers, RBG filters and a liquid crystal layer, arranged in such a way as to be able to display static and/or moving images when illuminated in a controlled manner and driven by the light sources 22 of the backlight assembly 20.

The LCD matrix 31 is supported by a diffuser screen 32, preferably a glass panel.

The LCD matrix 31 is permanently coupled to the diffuser screen 32 and is in direct contact therewith.

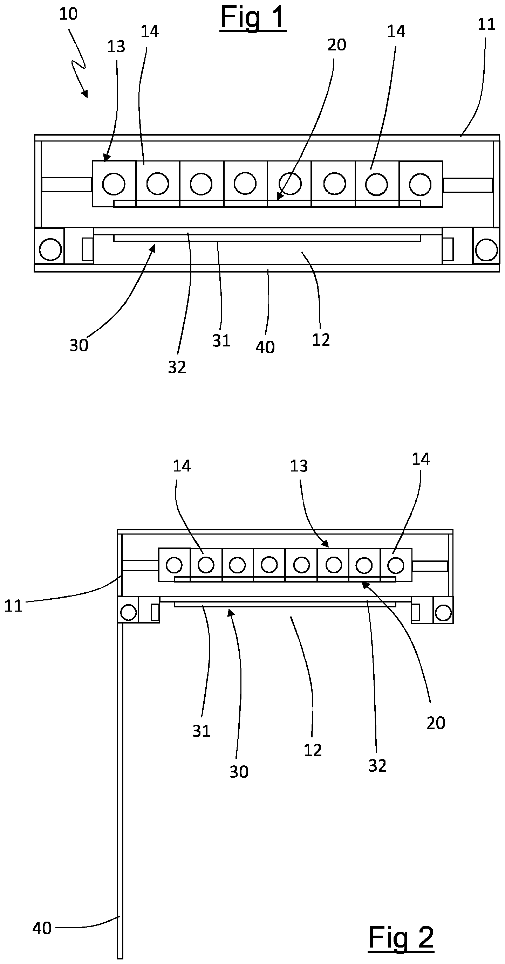

As illustrated in figure 1, the diffuser screen 32 is placed, in a transverse direction, between the LCD matrix 31 and the backlight assembly 20.

The diffuser screen 32 has dimensions such as to ensure a sealed closure of the front opening 12 of the containment structure 11.

The LCD matrix 31 may have smaller dimensions than the diffuser screen 32 and also smaller than the front opening 12 of the containment structure 11.

The LCD matrix 31 and the diffuser screen 32 define the display assembly 30.

The display assembly 30 is spaced, in a transverse direction, from the backlight assembly 20, as schematically shown in figure 1.

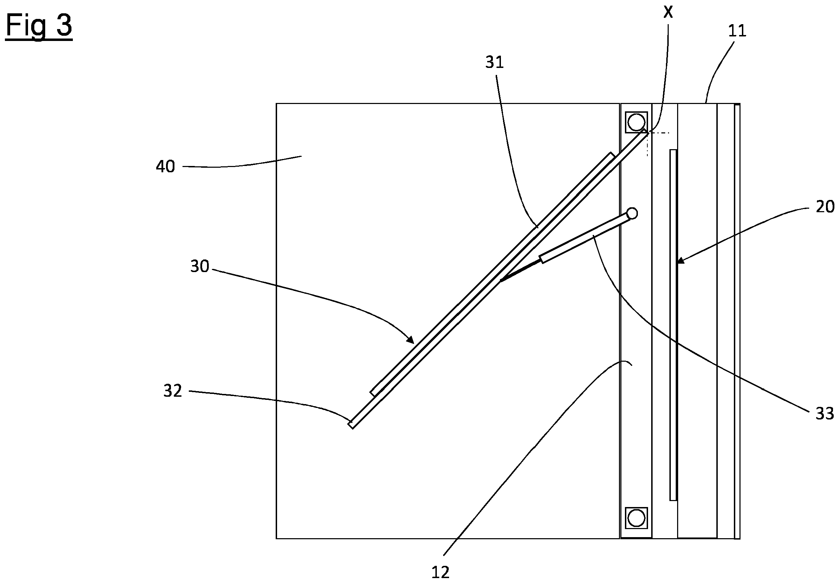

As shown in figure 3, the display assembly 30 is movable with respect to the containment structure 11, in particular it is movable with respect to the front opening 12.

The display assembly 30 is movable between an operating condition, in which it fluid-tightly closes the front opening 12 and a non-operating condition, in which it is moved away from the front opening 12.

In the operative condition, the display assembly 30 is placed in front of the backlight assembly 20, as described above, for reproducing static and/or moving images.

In the non-operating condition, the display assembly 30 is unable to effectively intercept the light emitted by the backlight assembly 20 and therefore cannot properly display static and/or moving images.

When in the non-operating condition, the display assembly 30 opens the front opening 12 and allows access inside the containment structure 11.

More particularly, when in the non-operating condition, the display assembly 30 allows direct access to the backlight assembly 20.

For this purpose, the display assembly 30 is hinged to the containment structure 11 along a straight hinge axis X.

In the preferred embodiment of the invention, the hinge axis X is a horizontal axis and the display assembly 30 is hinged in an upper portion of the containment structure 11.

The display assembly 30 is hinged to the containment structure 11 through the diffuser screen 32 which, supporting the LCD matrix 31, allows the whole display assembly 30 to rotate with respect to the containment structure 11, as shown in figure 3.

To allow easy and convenient movement of the display assembly 30, one, preferably two, pneumatic or hydraulic shock absorbers 33 are provided between the diffuser screen 32 and the containment structure 11.

Alternatively, or in combination with the shock absorber 33, an actuator (not shown) configured to move the display assembly 30 between the operating condition and the non-operating condition may be provided.

As stated above, when the display assembly 30 is in the non-operating condition, access to the backlight assembly 20 is allowed.

In this regard, the backlight assembly 20 is directly facing the front opening 12 of the containment enclosure 11.

Each led matrix 22 comprises a support 23 on which a predetermined number of led diodes 24 are mounted, preferably equidistant from each other.

The supports 23 are arranged parallel to the LCD matrix, when in the operating condition, and directly facing the diffuser screen 32 and spaced from it.

The LED drivers 21 are placed between the supports 23 (as illustrated in figure 8) or immediately behind the supports 23 on the opposite side with respect to the diffuser screen 32.

When the display assembly 30 is in the non-operating condition, the access to the LED drivers 21 is direct if the latters are placed between the supports 23 of the LED diodes 24.

In the event that the LED drivers 21 are mounted behind the supports 23, access to the LED drivers 23 requires removal of the supports 23.

Each LED driver 21 is configured to drive a LED array 22 or a group of LED arrays 22.

The LED drivers 21 are mounted on a first heatsink 13 arranged inside the containment structure 11.

The LED drivers 21 are thermally and physically coupled to the first heatsink 13 in such a way as to yield heat thereto.

It should be noted that the first heatsink 13 acts both as a structural support and as a cooling element for the LED drivers 21.

The first heatsink 13 also supports the LED arrays 22.

The first heatsink 13 comprises a plurality of modules 14 which are side by side in an axial direction, wherein the number of modules 14 is a function of the size of the electronic panel 10. In particular, the number of modules 14 is selected in such a way as to extend the first heatsink 13 by at least the entire axial extension of the backlight assembly 20. Likewise, the height, i.e. the vertical extension of the modules 14 is selected so as to extend at least throughout the height of the backlight assembly 20.

As illustrated in figure 9, each module 14 of the first heatsink 13 is a substantially prismatic body and comprises a front surface 14a facing the front opening 12 of the containment structure 11 and a rear surface 14b opposite the front surface 14a.

The led arrays 22 are mounted on the front surface 14a of each module 14 preferably through spacers (not shown) which distance the led arrays 21 from the first heatsink 13.

Between two axially adjacent modules 14 there is a recess 14c in which one or more LED drivers 21 are mounted (as shown schematically in figure 9).

Each LED driver 21 is preferably transversely and axially contained in a respective recess 14c so as not to project transversely with respect to the front surface 14a of the modules 14.

In this way, the LED arrays 22 can extend also at the recesses 14c and form a substantially continuous surface located at the front surfaces 14a of the modules 14.

In a direction transversally external to the display assembly 30 a front screen 40 is provided, preferably identical in shape, size and material to the diffuser screen 32 of the display assembly 30.

The front screen 40 is spaced from the display assembly 30 (for reasons which will appear clear hereinafter) and also fluid-tightly closes the front opening 12 of the containment structure 11.

The front screen 40 is hinged to the containment structure 11 so as to be moved between a closed condition of the front opening 12 (as shown in figure 1) and an opening condition, in which it allows free access to the front opening 12 and to the display assembly 30 (as illustrated in figure 2).

The front screen 40 is hinged to the containment structure 11 along a vertical axis at an axially outer end of the containment structure 11. In other words, the front screen 40 can be folded open with respect to the containment structure 11 to gain access to the display assembly 30.

Between the backlight assembly 20 and the display assembly 30 a circulation chamber 52 of a first closed circuit 51 is defined in which a cooling fluid circulates.

The first closed circuit 51, when the display assembly 30 is in the operating condition, is isolated from the environment outside the containment structure 11. The cooling fluid is in a gaseous state and can be air, nitrogen or an inert gas.

Each module 14 of the first heatsink comprises a respective inner through cavity 15 in fluid communication with an inlet and an outlet of an open cooling circuit, namely a cooling circuit that draws air from the environment outside the containment structure 11 and releases air into the environment outside the containment structure 11. The air from the external environment is drawn and expelled by flow generating members 16, such as fans, active on each inner cavity 15 in such a way as to establish a stream directed vertically within each module 14. The direction of this stream may be from the bottom upwards or from the top downwards.

Each module 14 is made of a metal material and is equipped with cooling fins (not shown) which extend into the inner cavity 15 projecting towards the center thereof, in such a way as to be impinged by the air flow passing through the inner cavity 15.

Said first closed circuit 51 comprises a heat regeneration chamber 53 arranged in fluid communication with the circulation chamber 12. The regeneration chamber 53 is thermally associated with the first heatsink 13, i.e. it exchanges thermal energy by convection with the first heatsink 13.

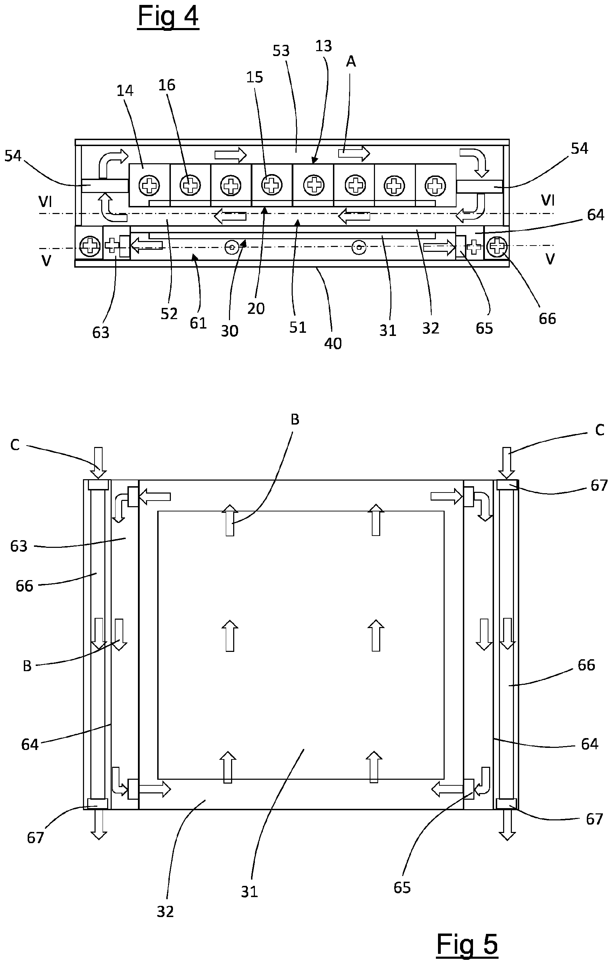

Fluid circulation members 54, such as fans, are active in the first closed circuit 51 for circulating the cooling fluid between the circulation chamber 52 and the regeneration chamber 53, as schematically illustrated in figure 4 and in the section in figure 8.

The regeneration chamber 53 is positioned transversally outside of the first heatsink 13, i.e. behind the same on the opposite side with respect to the backlight assembly 20, as indicated schematically in figure 4.

The flow of cooling fluid circulating in the regeneration chamber 53 flows on the first heatsink 13 to be cooled by thermal convection by the same.

The first closed circuit 51 therefore produces an annular path that internally encloses the first heatsink 13 and the backlight assembly 20. The direction of the cooling fluid flow in the first closed circuit 51, indicated by arrows A in figure 4, is axial and in counter-current in the circulation chamber 52 and in the regeneration chamber 53.

Between the front screen 40 and the display assembly 30, when the display assembly 30 and the front screen 40 are in operating condition, a circulation chamber 62 of a second closed circuit 61 is defined in which a further cooling fluid circulates.

The second closed circuit 61 comprises a heat regeneration chamber 63 arranged in fluid communication with the circulation chamber 62.

The display assembly 30 physically divides the first 51 from the second closed circuit 61, thus preventing the cooling fluids of the two circuits from coming into contact.

The regeneration chamber 63 comprises two vertical ducts 64, each of which is arranged transversally outside of, i.e. in front of, the circulation chamber 52 of the first closed circuit 51, as shown in figure 4.

Each of the two vertical ducts 64 is arranged axially outside of the circulation chamber 62 of the second closed circuit 61, out of the footprint of the further backlight assembly 20 and of the display assembly 30.

The flow of the cooling fluid in the circulation chamber 62 and in the vertical ducts 64 is directed vertically, as indicated by arrows B in figure 5. In particular, the flow of the cooling fluid in the second circulation chamber 62 is in counter-current with respect to the flow of cooling fluid in the two vertical ducts 64. Flow generating members 65, in particular fans, circulate the cooling fluid in the second closed circuit 61 and are arranged in the vicinity of the vertical ducts 64, sending cooling fluid from the circulation chamber 62 to the vertical ducts 64 and from the vertical ducts 64 to the circulation chamber 62.

The regeneration chamber 63 is thermally coupled to a second heatsink 66, in particular to a pair of second heatsinks 66 arranged axially outside of the regeneration chamber 62.

Each second heatsink 66 is structurally identical to one or more of the modules 14 that form the first heatsink 13 and is traversed by air drawn from the external environment, as indicated by arrows C in figure 5.

Preferably, at least one respective fan 67 is active in each second heatsink 66 to force the circulation of air drawn from the external environment. The two vertical ducts 64 are in direct contact with a respective second heatsink 66 in such a way as to cool the walls of the vertical ducts 64 and thus the cooling flow that circulates therein. The vertical ducts 64 are axially interposed between the second heatsinks 66 and the circulation chamber 62.

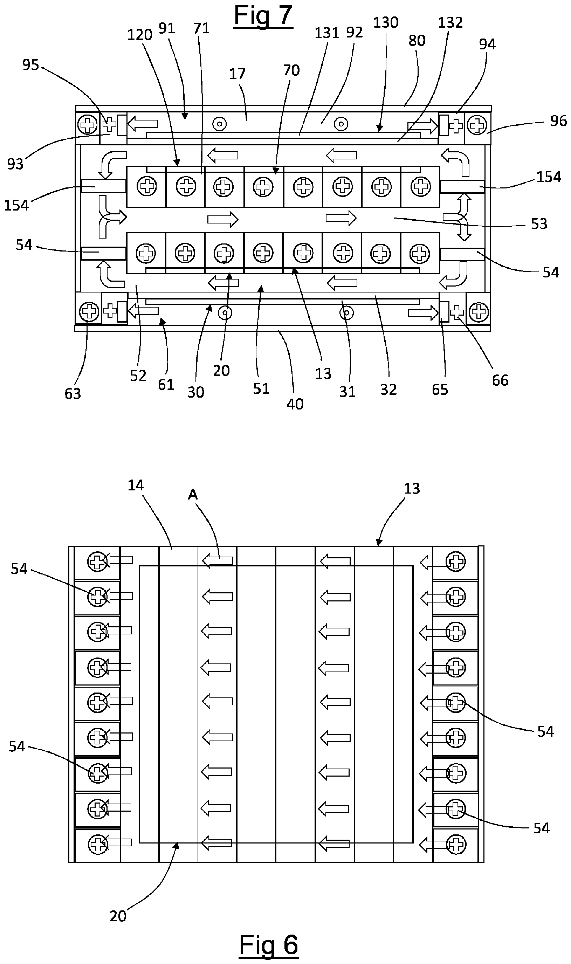

An embodiment variant of the electronic panel 10, shown in section in figure 7, relates to a two-sided panel, i.e. in which the images are displayed on two transversely opposite displays.

This embodiment variant is structurally and functionally given by the combination of two electronic panels 10 specular with respect to a vertical plane placed in the regeneration chamber 53 of the first closed circuit 51.

Therefore, a further backlight assembly 120 and a further display assembly 130 are provided facing each other (figure 7).

The further display assembly 130 is identical to the display assembly 30 and comprises an LCD matrix 131 and a diffuser screen 132 (figure 7).

The further backlight assembly 120 is identical to the backlight assembly 20 and comprises a plurality of electronic driving devices and a plurality of light sources driven by the electronic devices (not shown in detail).

The containment structure 11 has a rear opening 17 on which the further backlight assembly 120 faces, so that the light sources thereof radiate light towards the rear opening 17.

The rear opening 17 is fluid-tightly closed by the further display assembly 130 in which the led matrix 131 is placed transversely facing the further backlight assembly 120 in order to be illuminated directly thereby.

The diffuser screen 132 is placed, in a transverse direction, between the LED matrix 131 and the backlight assembly 120.

The diffuser screen 132 has dimensions such as to ensure a sealed closure of the rear opening 17 of the containment structure 11.

The further display assembly 130 is movable with respect to the containment structure 11, in particular it is movable with respect to the rear opening 17.

The further display assembly 130 is movable between an operating condition, in which it fluid-tightly closes the rear opening 17 and a non-operating condition, in which it is moved away from the rear opening 17.

When in the non-operating condition, the further display assembly 130 opens the rear opening 17 and allows access inside the containment structure 11.

More particularly, when in the non-operating condition, the further display assembly 130 allows direct access to the further backlight assembly 120.

The further display assembly 130 is hinged to the containment structure 11 in the same manner described in relation to the display assembly 30.

The further backlight assembly 130 is mounted on a third heatsink 70 exactly as the backlight assembly 30 is mounted on the first heatsink 13.

The third heatsink 70 is preferably identical in shape and structure to the first heatsink 13 and comprises a plurality of modules 71 which are side by side in an axial direction, wherein the number of modules 71 is a function of the size of the electronic panel 10. In particular, the number of modules 71 is selected in such a way as to extend the third heatsink 70 by at least the entire axial extension of the further backlight assembly 120. Likewise, the height, i.e. the vertical extension of the modules 71 is selected so as to extend at least throughout the height of the further backlight assembly 120.

Each module 71 of the third heatsink 70 is a substantially prismatic body and comprises a front surface 71a facing the rear opening 17 of the containment structure 11 and a rear surface 71b opposite the front surface 71a.

In a direction transversally external to the further display assembly 30 a rear screen 80 is provided, preferably identical in shape, size and material to the front screen 40.

The rear screen 80 is spaced from the further display assembly 130 and fluid-tightly closes the rear opening 17 of the containment structure 11.

The rear screen 80 is hinged to the containment structure 11 so as to be moved between a closed condition of the rear opening 12 and an open condition, in which it allows free access to the rear opening 17 and to the further display assembly 130.

In this embodiment, the circulation chamber 52 of the first closed circuit 51 also develops between the further backlight assembly 120 and the further display assembly 130.

The third heatsink 70 is transversally spaced from the first one 13 and the space between them is occupied by the regeneration chamber 53 of the first closed circuit 51. The regeneration chamber 53 is common to both portions of the circulation chamber 52. Further fans 154 circulate cooling fluid also in the portion of circulation chamber arranged between the further backlight assembly 120 and the further display assembly 130.

Transversally outside of the portion of the circulation chamber 52 arranged between the further backlight assembly 130 and the further display assembly 130 there is provided a third closed circuit 91 identical and transversally specular with respect to the second closed circuit 61.

The third closed circuit 91 comprises a circulation chamber 92 and a regeneration chamber 93 arranged in fluid communication with the circulation chamber 92.

The circulation chamber 92 is formed between the further display assembly 130 and the rear screen 80 and is separated from the circulation chamber 52 of the first closed circuit 51. The regeneration chamber 93 comprises two vertical ducts 94, each of which is arranged transversally outside of, i.e. in front of, the circulation chamber 52 of the first closed circuit 51, as shown in figure 7. Each of the two vertical ducts 94 is arranged axially outside of the circulation chamber 92 of the third closed circuit 91, out of the footprint of the further backlight assembly 120 and of the further display assembly 130. The flow of the cooling fluid in the circulation chamber 92 and in the lateral ducts 94 is directed vertically. In particular, the flow of the cooling fluid in the second circulation chamber 92 is in counter-current with respect to the flow of cooling fluid in the two vertical ducts 94. Flow generating members 95, in particular fans, circulate the cooling fluid in the third closed circuit 91 and are arranged in the vicinity of the vertical ducts 94, sending cooling fluid from the circulation chamber 92 to the vertical ducts 94 and from the vertical ducts 94 to the circulation chamber 92.

The regeneration chamber 93 is thermally coupled to a fourth heatsink 96, in particular to a pair of second heatsinks 96 arranged axially outside of the regeneration chamber 93.

Each fourth heatsink 96 is structurally identical to one or more of the modules 14 that form the first heatsink 13 and is traversed by air drawn from the external environment. Preferably, at least one respective fan is active in each fourth heatsink 96 to force the circulation of air drawn from the external environment. The two vertical ducts 94 are in direct contact with a respective fourth heatsink 96 in such a way that the latter can cool the walls of the vertical ducts 94 and thus the cooling flow that circulates therein. The vertical ducts 94 are axially interposed between the fourth heatsinks 96 and the circulation chamber 92.

Of course, a man skilled in the art may make several changes and adjustments to the invention described above in order to meet specific and incidental needs, all falling within the scope of protection of the present invention as defined in the following claims.

## Claims

1. An electronic panel (10) for digital signs comprising:
a backlight assembly (20) comprising a plurality of light sources (22) and of electronic devices (21) for driving them;
a display assembly (30) comprising a plurality of layers configured to display images;
a containment structure (11) in which is contained said backlight assembly (20) and comprising a front opening (12) for housing said display assembly (30);
said display assembly (30) being movable between an operating condition wherein it faces said backlight assembly (20) and closes said front opening (12) of the containment structure (11), and a non-operating condition wherein it is moved away from said backlight assembly (20) and it opens said front opening (12) of the containment structure (11),
**characterized in that**
said backlight assembly (20) being mounted on a first heatsink (13) on a front surface (14a) thereof facing towards said front opening (12) of said containment structure (11) and said plurality of light sources (22) and of electronic devices (21) for driving them being mounted on said front surface (14a) of the first heatsink (13).

2. An electronic panel (10) according to claim 1, wherein said display assembly (30) is hinged to said containment structure (11) and said backlight assembly (20) is fixed with respect to said containment structure (11).

3. An electronic panel (10) according to claim 1 or 2, wherein said display assembly (30), in the operating condition, fluid-tightly closes said backlight assembly (20) in said containment structure (11) and, in the non-operating condition, exposes said backlight assembly (20) to the environment external to said containment structure (11).

4. An electronic panel (10) according to claim 1, wherein said electronic devices (21) for driving the light sources (22) are thermally coupled to said first heatsink (13).

5. An electronic panel (10) according to claim 1 or 4, wherein said front surface (14a) of the first heatsink comprises a plurality of recesses (14c) in which are accommodated said electronic devices (21) for driving the light sources (22).

6. An electronic panel (10) according to any one of claims 1, 4 or 5, wherein said first heatsink (13) comprises a plurality of modules (14) provided with respective inner through cavities (15) placed in fluid communication with the environment external to said containment structure (11).

7. An electronic panel (10) according to any one of the preceding claims, wherein said containment structure (11) and said display assembly (30), in the operating condition, define a first closed circuit (51) wherein a cooling fluid circulates which laps the backlight assembly (20).

8. An electronic panel (10) according to claim 7, wherein said first closed circuit (51) comprises a thermal regeneration chamber (53) for said cooling fluid, thermally associated with said first heatsink (13).

9. An electronic panel (10) according to claim 3, wherein said display assembly (30) comprises an LCD matrix (31) coupled to a diffuser screen (32); said diffuser screen (32), in the operating condition of the display assembly (30), fluid-tightly closes said front opening (12) of the containment structure (11).

10. An electronic panel (10) according to any one of the preceding claims, comprising a front screen (40) which is movable between an operating condition wherein it is facing said display assembly (30) on the side opposite to the backlight assembly (20), and a non-operating condition wherein it is moved away from said display assembly (30).

11. An electronic panel (10) according to claim 10, wherein said front screen (40) and said display assembly (30) define, when they are in their respective operating conditions, a second closed circuit (61) wherein a cooling fluid circulates which laps said display assembly (30).

12. An electronic panel (10) according to claim 11, comprising a second heatsink (66); said second closed circuit (61) comprising a thermal regeneration chamber (63) for said cooling fluid thermally associated with the second heatsink (66).

13. An electronic panel (10) according to claim 7 and 11, wherein said display assembly (30) physically divides the first closed circuit (51) from the second closed circuit (61) and prevents the cooling fluids of the first closed circuit (51) and of the second closed circuit (61) from coming into contact.

14. An electronic panel (10) according to claim 9, wherein the display assembly (30) is hinged to the containment structure (11) through the diffuser screen (32).

## Patentansprüche

1. Elektronische Tafel (10) für digitale Schilder, umfassend:
eine Hintergrundbeleuchtungsanordnung (20), umfassend eine Vielzahl von Lichtquellen (22) und elektronischen Vorrichtungen (21) für deren Betrieb;
eine Anzeigenanordnung (30), umfassend eine Vielzahl von Schichten, die konfiguriert sind, Bilder anzuzeigen;
eine Gehäusestruktur (11), in der die Hintergrundbeleuchtungsanordnung (20) eingehaust ist und umfassend eine Frontöffnung (12) zum Einhausen der Anzeigenanordnung (30);
wobei die Anzeigenanordnung (30) zwischen einem Betriebszustand, in dem sie der Hintergrundbeleuchtungsanordnung (20) zugewandt ist und die Frontöffnung (12) der Gehäusestruktur (11) verschließt, und einem Nicht-Betriebszustand, in dem sie von der Hintergrundbeleuchtungsanordnung (20) wegbewegt ist und die Frontöffnung (12) der Gehäusestruktur (11) öffnet,
**dadurch gekennzeichnet, dass**
die Hintergrundbeleuchtungsanordnung (20) auf einem ersten Kühlkörper (13) auf einer Frontoberfläche (14a) davon, die der Frontöffnung (12) der Gehäusestruktur (11) zugewandt ist, montiert ist und die Vielzahl von Lichtquellen (22) und elektronischen Vorrichtungen (21) zum Betreiben davon auf der Frontoberfläche (14a) des ersten Kühlkörpers (13) montiert sind.

2. Elektronische Tafel (10) nach Anspruch 1, wobei die Anzeigenanordnung (30) an die Gehäusestruktur (11) angelenkt ist und die Hintergrundbeleuchtungsanordnung (20) in Bezug auf die Gehäusestruktur (11) fixiert ist.

3. Elektronische Tafel (10) nach Anspruch 1 oder 2, wobei die Anzeigenanordnung (30) im Betriebszustand die Hintergrundbeleuchtungsanordnung (20) in der Gehäusestruktur (11) fluiddicht einschließt und die Hintergrundbeleuchtungsanordnung (20) im Nicht-Betriebszustand gegenüber der äußeren Umgebung der Gehäusestruktur (11) freilegt.

4. Elektronische Tafel (10) nach Anspruch 1, wobei die elektronischen Vorrichtungen (21) zum Betreiben der Lichtquellen (22) thermisch mit dem ersten Kühlkörper (13) gekoppelt sind.

5. Elektronische Tafel (10) nach Anspruch 1 oder 4, wobei die Frontoberfläche (14a) des ersten Kühlkörpers eine Vielzahl von Vertiefungen (14c) umfasst, in denen die elektronischen Vorrichtungen (21) zum Betreiben der Lichtquellen (22) aufgenommen sind.

6. Elektronische Tafel (10) nach einem der Ansprüche 1, 4 oder 5, wobei der erste Kühlkörper (13) eine Vielzahl von Modulen (14) umfasst, die mit entsprechenden inneren Durchgangshohlräumen (15) versehen sind, die in Fluidkommunikation mit der äußerem Umgebung der Gehäusestruktur (11) stehen.

7. Elektronische Tafel (10) nach einem der vorstehenden Ansprüche, wobei die Gehäusestruktur (11) und die Anzeigenanordnung (30) im Betriebszustand einen ersten geschlossenen Kreislauf (51) definieren, worin ein Kühlfluid zirkuliert, das die Hintergrundbeleuchtungsanordnung (20) kontaktiert.

8. Elektronische Tafel (10) nach Anspruch 7, wobei der erste geschlossene Kreislauf (51) eine Wärmeregenerationskammer (53) für das Kühlfluid umfasst, die thermisch mit dem ersten Kühlkörper (13) in Verbindung steht.

9. Elektronische Tafel (10) nach Anspruch 3, wobei die Anzeigeanordnung (30) eine LCD-Matrix (31) umfasst, die mit einer Streuscheibe (32) gekoppelt ist; wobei die Streuscheibe (32) im Betriebszustand der Anzeigenanordnung (30) die Frontöffnung (12) der Gehäusestruktur (11) fluiddicht abschließt.

10. Elektronische Tafel (10) nach einem der vorstehenden Ansprüche, umfassend einen Frontbildschirm (40), der zwischen einem Betriebszustand, in dem er der Anzeigenanordnung (30) auf der Seite gegenüber der Hintergrundbeleuchtungsanordnung (20) zugewandt ist, und einem Nicht-Betriebszustand, in dem er von der Anzeigenanordnung (30) wegbewegt ist, bewegbar ist.

11. Elektronische Tafel (10) nach Anspruch 10, wobei der Frontbildschirm (40) und die Anzeigenanordnung (30), wenn sie sich in ihrem jeweiligen Betriebszustand befinden, einen zweiten geschlossenen Kreislauf (61) definieren, worin ein Kühlfluid zirkuliert, das die Anzeigenanordnung (30) kontaktiert.

12. Elektronische Tafel (10) nach Anspruch 11, umfassend einen zweiten Kühlkörper (66); wobei der zweite geschlossene Kreislauf (61) eine Wärmeregenerationskammer (63) für das Kühlfluid umfasst, die thermisch mit dem zweiten Kühlkörper (66) in Verbindung steht.

13. Elektronische Tafel (10) nach Anspruch 7 und 11, wobei die Anzeigenanordnung (30) den ersten geschlossenen Kreislauf (51) von dem zweiten geschlossenen Kreislauf (61) physikalisch abtrennt und verhindert, dass die Kühlfluide des ersten geschlossenen Kreislaufs (51) und des zweiten geschlossenen Kreislaufs (61) miteinander in Kontakt geraten.

14. Elektronische Tafel (10) nach Anspruch 9, wobei die Anzeigenanordnung (30) durch die Streuscheibe (32) an die Gehäusestruktur (11) angelenkt ist.

## Revendications

1. Panneau électronique (10) pour panneaux numériques comprenant :
un ensemble de rétroéclairage (20) comprenant une pluralité de sources de lumière (22) et de dispositifs électroniques (21) pour les attaquer ;
un ensemble d'affichage (30) comprenant une pluralité de couches configurées pour afficher des images ;
une structure de réception (11) dans laquelle est reçu ledit ensemble de rétroéclairage (20) et comprenant une ouverture avant (12) pour loger ledit ensemble d'affichage (30) ;
ledit ensemble d'affichage (30) étant mobile entre un état de fonctionnement dans lequel il fait face audit ensemble de rétroéclairage (20) et ferme ladite ouverture avant (12) de la structure de réception (11), et un état de non-fonctionnement dans lequel il est éloigné dudit ensemble de rétroéclairage (20) et il ouvre ladite ouverture avant (12) de la structure de réception (11), **caractérisé en ce que**
ledit ensemble de rétroéclairage (20) étant monté sur un premier dissipateur de chaleur (13) sur une surface avant (14a) de celui-ci faisant face en direction de ladite ouverture avant (12) de ladite structure de réception (11) et ladite pluralité de sources de lumière (22) et de dispositifs électroniques (21) pour les attaquer étant montée sur ladite surface avant (14a) du premier dissipateur de chaleur (13).

2. Panneau électronique (10) selon la revendication 1, dans lequel ledit ensemble d'affichage (30) est articulé sur ladite structure de réception (11) et ledit ensemble de rétroéclairage (20) est fixe par rapport à ladite structure de réception (11).

3. Panneau électronique (10) selon la revendication 1 ou 2, dans lequel ledit ensemble d'affichage (30), dans l'état de fonctionnement, ferme de manière étanche aux fluides ledit ensemble de rétroéclairage (20) dans ladite structure de réception (11) et, dans l'état de non-fonctionnement, expose ledit ensemble de rétroéclairage (20) à l'environnement extérieur à ladite structure de réception (11).

4. Panneau électronique (10) selon la revendication 1, dans lequel lesdits dispositifs électroniques (21) pour attaquer les sources de lumière (22) sont thermiquement couplés audit premier dissipateur de chaleur (13).

5. Panneau électronique (10) selon la revendication 1 ou 4, dans lequel ladite surface avant (14a) du premier dissipateur de chaleur comprend une pluralité d'évidements (14c) dans lesquels sont reçus lesdits dispositifs électroniques (21) pour attaquer les sources de lumière (22).

6. Panneau électronique (10) selon l'une quelconque des revendications 1, 4 ou 5, dans lequel ledit premier dissipateur de chaleur (13) comprend une pluralité de modules (14) munis de cavités passantes internes respectives (15) placées en communication fluidique avec l'environnement extérieur à ladite structure de réception (11).

7. Panneau électronique (10) selon l'une quelconque des revendications précédentes, dans lequel ladite structure de réception (11) et ledit ensemble d'affichage (30), dans l'état de fonctionnement, définissent un premier circuit fermé (51) dans lequel un fluide de refroidissement circule qui encercle l'ensemble de rétroéclairage (20).

8. Panneau électronique (10) selon la revendication 7, dans lequel ledit premier circuit fermé (51) comprend une chambre de régénération thermique (53) pour ledit fluide de refroidissement, thermiquement associée audit premier dissipateur de chaleur (13).

9. Panneau électronique (10) selon la revendication 3, dans lequel ledit ensemble d'affichage (30) comprend une matrice d'afficheur à cristaux liquides, LCD (31), couplée à un écran diffuseur (32) ; ledit écran diffuseur (32), dans l'état de fonctionnement de l'ensemble d'affichage (30), ferme de manière étanche aux fluides ladite ouverture avant (12) de la structure de réception (11).

10. Panneau électronique (10) selon l'une quelconque des revendications précédentes, comprenant un écran avant (40) qui est mobile entre un état de fonctionnement dans lequel il fait face audit ensemble d'affichage (30) sur le côté opposé à l'ensemble de rétroéclairage (20) et un état de non-fonctionnement dans lequel il est éloigné dudit ensemble d'affichage (30).

11. Panneau électronique (10) selon la revendication 10, dans lequel ledit écran avant (40) et ledit ensemble d'affichage (30) définissent, lorsqu'ils sont dans leurs états de fonctionnement respectifs, un second circuit fermé (61) dans lequel un fluide de refroidissement circule qui encercle ledit ensemble d'affichage (30).

12. Panneau électronique (10) selon la revendication 11, comprenant un second dissipateur de chaleur (66) ; ledit second circuit fermé (61) comprenant une chambre de régénération thermique (63) pour ledit fluide de refroidissement, thermiquement associée au second dissipateur de chaleur (66).

13. Panneau électronique (10) selon les revendications 7 et 11, dans lequel ledit ensemble d'affichage (30) sépare physiquement le premier circuit fermé (51) du second circuit fermé (61) et empêche les fluides de refroidissement du premier circuit fermé (51) et du second circuit fermé (61) d'entrer en contact.

14. Panneau électronique (10) selon la revendication 9, dans lequel l'ensemble d'affichage (30) est articulé sur la structure de réception (11) par l'intermédiaire de l'écran diffuseur (32).
